(19) **Europäisches Patentamt**
**European Patent Office**
**Office européen des brevets**

(11) **EP 1 269 561 B1**

(12) **EUROPÄISCHE PATENTSCHRIFT**

(45) Veröffentlichungstag und Bekanntmachung des Hinweises auf die Patenterteilung:
**10.01.2007 Patentblatt 2007/02**

(21) Anmeldenummer: **01929503.9**

(22) Anmeldetag: **04.04.2001**

(51) Int Cl.:
***H01P 1/15*** (2006.01)          ***H03M 1/00*** (2006.01)

(86) Internationale Anmeldenummer:
**PCT/EP2001/003845**

(87) Internationale Veröffentlichungsnummer:
**WO 2001/078186 (18.10.2001 Gazette 2001/42)**

(54) **BAUELEMENT MIT EINER INTEGRIERTEN HOCHFREQUENZSCHALTUNG**

COMPONENT WITH AN INTEGRATED HIGH-FREQUENCY CIRCUIT

COMPOSANT DOTE D'UN CIRCUIT INTEGRE HAUTE FREQUENCE

(84) Benannte Vertragsstaaten:
**DE FR GB IT**

(30) Priorität: **05.04.2000 EP 00107389**

(43) Veröffentlichungstag der Anmeldung:
**02.01.2003 Patentblatt 2003/01**

(73) Patentinhaber: **Infineon Technologies AG**
**81669 München (DE)**

(72) Erfinder:
• **LOSEHAND, Reinhard**
**80637 München (DE)**

• **PEICHL, Raimund**
**85635 Höhenkirchen-Siegertsbrunn (DE)**
• **ZIMMERMANN, Walter**
**84405 Dorfen (DE)**

(74) Vertreter: **Epping - Hermann - Fischer**
**Ridlerstrasse 55**
**80339 München (DE)**

(56) Entgegenhaltungen:
**EP-A- 0 364 035          EP-A- 0 409 374**
**FR-A- 2 582 150          US-A- 3 890 610**
**US-A- 4 249 144**

**Beschreibung**

Die Erfindung betrifft ein Bauelement mit einer integrierten Hochfrequenzschaltung, die einen Schwingkreis mit einer Kapazität aufweist, deren Wert für einen vorgegebenen Frequenzbereich durch eine Abstimmdiode einstellbar ist.

Bisher werden im Frequenzbereich von 1,5 bis 3 Gigahertz keine integrierten Bauelemente für Schwingkreise oder Signalgeneratoren verwendet. Derzeit kommen entweder diskrete Spulen und Kapazitätsdioden zum Einsatz oder es werden Module aus mehreren integrierten Bauelementen in einem Gehäuse verwendet.

Es besteht jedoch Bedarf an integrierten Bauelementen mit Schwingkreisen oder Signalgeneratoren. Insbesondere werden abstimmbare, spannungsgesteuerte integrierte Bauelemente benötigt. Die üblichen Schaltungen für spannungsgesteuerte Schwingkreise enthalten zumindest eine Abstimmdiode, an denen eine gegen die Flußrichtung gepolte Gleichspannung als Vorspannung anliegt. Die Sperrschichtkapazität der Abstimmdiode ist dann eine monotone Funktion dieser Vorspannung. Der Schwingkreis verfügt daher über eine spannungsgeregelte Kapazität, mit der die Resonanzfrequenz des Schwingkreises eingestellt werden kann. Die Vorspannung dient dabei zum Durchfahren des nutzbaren Frequenzbandes.

Die Spezifikation eines fertigen integrierten Bauelements mit einem Schwingkreis enthält auch einen definierten Zusammenhang zwischen Vorspannung und Resonanzfrequenz. Da jedoch die elektrischen Eigenschaften aller Schaltungselemente in einem Toleranzbereich schwanken können, muß die Möglichkeit bestehen, die Resonanzfrequenz des Schwingkreises abzugleichen.

Aus dem Buch "Microwave and Wireless Synthesizers" von Ulrich L. Rohde, New York 1997, Seiten 62 und 63 ist bekannt, die Feinsteuerung eines Schwingkreises durch eine Abstimmdiode vorzunehmen, an der eine gegen die Flußrichtung gepolte Gleichspannung als Vorspannung anliegt. Parallel zu der Abstimmdiode sind zwei gegeneinander gepolte, zweite und dritte Abstimmdioden vorgesehen, zwischen denen eine Gleichspannung als Vorspannung anliegt, durch die eine Grobsteuerung der Resonanzfrequenz des Schwingkreises vorgenommen werden kann.

In der EP-A-0 364 035 ist ein Hochfrequenzfilter angegeben, bei dem kapazitive Abstimmung mittels zweier steuerbarer Dioden ermöglicht ist. Eine Abstimmung des Schwingkreises kann gemäß einer der dort beschriebenen Ausführungsformen durch Digital-Analog-Wandlung eines digitalen Zählerwerts erreicht werden. Der Zählerwert wird in einem Speicher zwischengespeichert.

In der US-A-3 890 610 ist ein Digital-Analog-Wandler für hohe Genauigkeit beschrieben. Der A/D-Wandler weist ein Netzwerk mit Längs- und Querwiderständen auf. Die Querwiderstände sind über Impedanzwandler weiter verschaltbar. Schmelzbrücken dienen dazu, um die verschiedenen Stufen des A/D-Wandlers miteinander zu verbinden. Die Querwiderstände weisen einen Wert von 2R auf, die Längswiderstände einen Wert von R.

Der Erfindung liegt die Aufgabe zugrunde, ein Bauelement mit einer integrierten Schaltung anzugeben, die einen abstimmbaren, spannungsgesteuerten Schwingkreis enthält, dessen herstellungsbedingte Abweichungen in der Resonanzfrequenz kompensierbar sind.

Gemäß der Erfindung wird diese Aufgabe gelöst durch ein Bauelement mit einer integrierten Schaltung für Hochfrequenzanwendungen in einem vorgegebenen Frequenzbereich, bei dem die integrierte Schaltung einen Schwingkreis mit einer Kapazität aufweist, deren Wert durch eine Abstimmdiode einstellbar ist, und weiterhin umfaßt: einen Abstimmeingang, einen Abgleicheingang und einen Schwingkreis, eine Abstimmdiode, die an den Abstimmeingang gekoppelt ist, eine im Schwingkreis angeordnete Abgleichdiode, die an den Abgleicheingang gekoppelt ist, wobei durch die Abgleichdiode die herstellungsbedingten Abweichungen in der Resonanzfrequenz des Schwingkreises kompensierbar sind, einen Digital-Analog-Wandler, der eine Kette von Längswiderständen aufweist, zwischen denen Querwiderstände angeschlossen sind, weiterhin Schmelzverbindungen, eine Masseleitung, um ein Massepotential zu führen, und eine Referenzspannungsleitung aufweist, um eine Referenzspannung zu führen und bei dem durch Brennen des Schmelzverbindungen (17) ein Digitalwert programmiert ist, so dass aus der Referenzspannung (Vref) eine Abgleichspannung (Vtol) erzeugt wird, die dem Abgleicheingang (10) zugeführt wird, wobei je zwei der Schmelzverbindungen an einen der Querwiderstände geschaltet sind, um die Querwiderstände in Abhängigkeit von dem durch die Schmelzverbindungen programmierten Digitalwert wahlweise mit der Masseleitung oder der Referenzspannungsleitung zu verbinden, so daß die Abgleichspannung erzeugt wird.

Des Weiteren wird eine Verwendung eines Bauelements für Hochfrequenzanwendungen zum Abgleichen von herstellungsbedingten Abweichungen im nebengeordneten Patentanspruch 9 angegeben.

Bei dem Bauelement gemäß der Erfindung genügt es, wenn der Anwender eine vorgegebene Referenzspannung an einen dafür vorgesehenen Eingang des Bauelements anlegt. Das Bauelement erzeugt dann aus der Referenzspannung die für die jeweilige Kompensation erforderliche Abgleichspannung. Der im Speicher abgelegte Digitalwert wird zweckmäßigerweise bei einer Endmessung vor der Auslieferung des Bauelements ermittelt und im Speicher abgelegt. Es genügt daher, daß der Anwender das Bauelement mit einer stabilen Referenzspannung versorgt, um den spezifizierten Zusammenhang zwischen Abstimmspannung und Resonanzfrequenz zu gewährleisten.

Der Digital-Analog-Wandler ist durch eine Kette von Längswiderständen bewerkstelligt, zwischen denen Querwiderstände angeschlossen sind, die über Schmelzbrücken wahlweise mit einer Masseleitung oder der Referenzspannung verbindbar sind.

Mit Hilfe der Schmelzbrücken und den Widerständen läßt sich ein einfacher programmierbarer Digital-Analog-Wandler herstellen, der durch Brennen der Schmelzbrücken programmierbar ist.

Weitere zweckmäßige Ausgestaltung sind Gegenstand der abhängigen Ansprüche.

Nachfolgend wird ein Ausführungsbeispiel der Erfindung anhand der beigefügten Zeichnung erläutert. Es zeigen:

Figur 1      die Schaltungsanordnung eines abstimmbaren und abgleichbaren, spannungsgesteuerten Schwingkreises;

Figur 2      die Schaltungsanordnung eines programmierbaren Digital-Analog-Wandlers; und

Figur 3A und 3B      Einstellmöglichkeiten für Schmelzbrücken des Digital-Analog-Wandlers aus Figur 2.

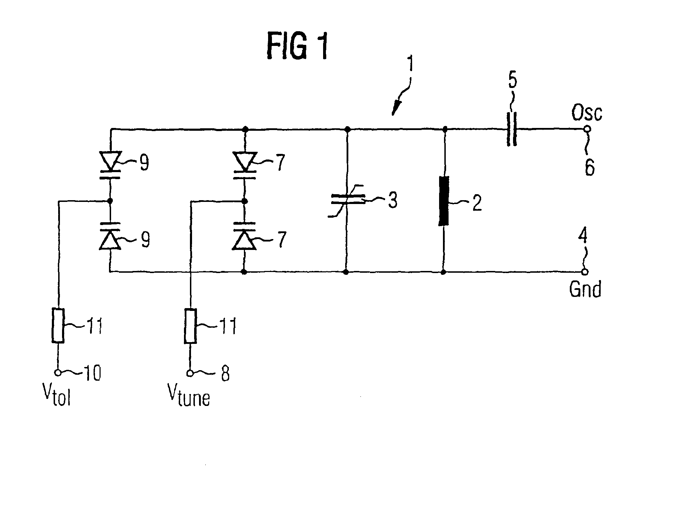

In Figur 1 ist die Schaltungsanordnung eines abstimmbaren und abgleichbaren, spannungsgesteuerten Schwingkreises 1 dargestellt. Der Schwingkreis 1 umfaßt eine Induktivität 2 und eine Kapazität 3 und ist an einen Masseanschluß 4 sowie über einen Koppelkondensator 5 an einen Signalausgang 6 angeschlossen. Parallel zur Kapazität 3 sind zwei gegeneinander gepolte Abstimmdioden 7 geschaltet, zwischen denen eine an einem Abstimmeingang 8 anliegende Abstimmspannung anliegt. Ebenfalls parallel zur Kapazität 3 geschaltet sind gegeneinander gepolte Abgleichdioden 9, zwischen denen eine an einem Abgleicheingang 10 anliegende Abgleichspannung anliegt. Der Abstimmeingang 8 und der Abgleicheingang 10 sind jeweils durch Vorwiderstände 11 geschützt. Bei den Abstimmdioden 7 und den Abgleichdioden 9 handelt es sich um sogenannte Kapazitätsdioden, deren Sperrschichtkapazität bei Polung gegen die Flußrichtung eine monotone Funktion der an den Kapazitätsdioden anliegenden Spannung ist. Bei der in Figur 1 dargestellten Schaltungsanordnung ist die am Abstimmeingang 8 anliegende Abstimmspannung so groß, daß die Abstimmdioden 7 auf einen Arbeitspunkt eingestellt werden, in dem die Sperrschichtkapazität der Abstimmdioden 7 eine monotone Funktion der am Abstimmeingang 8 anliegenden Abstimmspannung sind. Entsprechend stellt die am Abgleicheingang 10 anliegende Abgleichspannung die Abgleichdioden 9 auf einen Arbeitspunkt ein, in dem die Sperrschichtkapazität der Abgleichdioden 9 eine monotone Funktion der Abgleichspannung ist. Da die Abstimmdioden 7 und die Abgleichdioden 9 durch das vom Schwingkreis 1 erzeugte Wechselstromsignal nur wenig in ihrem Arbeitspunkt ausgelenkt werden, kann die Kapazität der Abstimmdioden 7 und der Abgleichdioden 9 im wesentlichen als konstant angesehen werden. Durch die Abstimmspannung und die Abgleichspannung kann somit die Gesamtkapazität im Schwingkreis 1 gesteuert werden. Insbesondere ist es möglich, durch eine Veränderung der Abstimmspannung die Resonanzfrequenz des Schwingkreises 1 zu verändern.

Bei einem integrierten Bauelement ist es wünschenswert, daß ein spezifizierter Zusammenhang zwischen der jeweiligen Abstimmspannung und der Resonanzfrequenz besteht. Die elektrischen Eigenschaften der Induktivität 2 und der Kapazität 3 sowie der Abstimmdioden 7 schwanken jedoch herstellungsbedingt innerhalb bestimmter vorgegebener Toleranzbereiche. Es ist daher von Vorteil, wenn eine Möglichkeit besteht, diese Schwankungen auszugleichen. Diesem Zweck dienen die Abgleichdioden 9, die entsprechend der Abgleichspannung die fertigungsbedingten Toleranzen ausgleichen und auf diese Weise den spezifizierten Zusammenhang zwischen Abgleichspannung und Resonanzfrequenz gewährleisten.

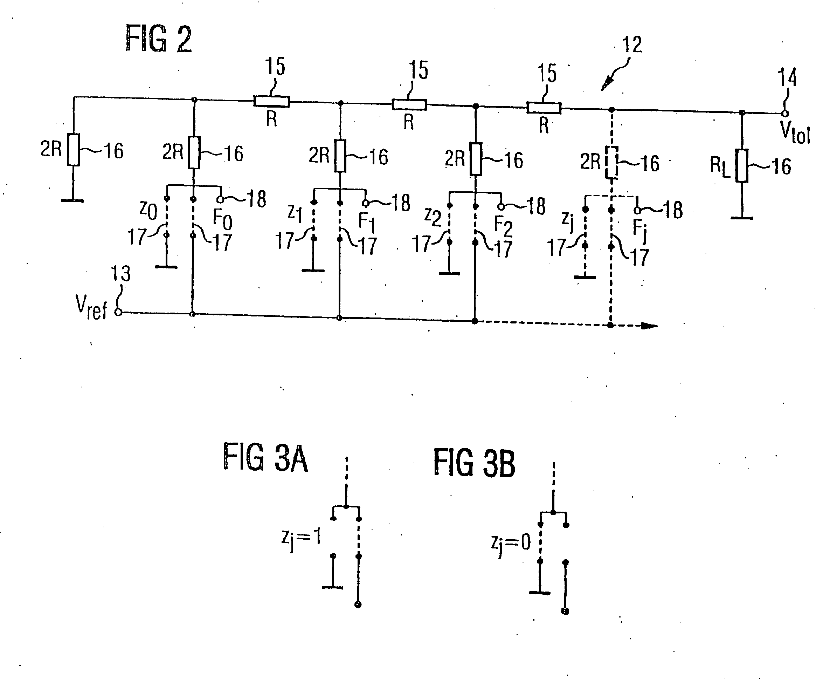

Figur 2 zeigt einen in das Bauelement integrierbaren Digital-Analog-Wandler, der dazu dient, aus einer an einem Referenzeingang 13 anliegenden Referenzspannung die Abgleichspannung an einem Abgleichausgang 14 zu erzeugen.

Der Digital-Analog-Wandler 12 weist ein invers betriebenes programmierbares Leiternetzwerk mit einer Kette von Längswiderständen 15 auf, die an den Abgleichausgang 14 angeschlossen ist. Quer zu den Längswiderständen 15 sind Querwiderstände 16 geschaltet.

Die Querwiderstände 16 sind über paarweise vorhandene Schmelzbrücken 17 wahlweise mit Masse oder mit dem Referenzeingang verbindbar. Unter Schmelzbrücken 17 sollen sowohl sogenannte Fuses als auch Antifuses verstanden werden. Außerdem sind Schmelzeingänge 18 vorgesehen, die zum Brennen der Schmelzbrücken 17 dienen. Zu diesem Zweck werden an die Schmelzeingänge 18 und den Referenzeingang 13 Spannungen F0, F1, F2, Fj angelegt, deren Höhe so gewählt ist, daß jeweils eine der beiden Schmelzbrücken 17 durchtrennt oder geschlossen wird.

In Figur 3A und 3B sind mögliche Schaltzustände dargestellt. Der Schaltzustand in Figur 3A soll eine logische 1 darstellen, während der Schaltzustand in Figur 3B eine logische 0 darstellt. Für ein Leiternetzwerk mit 2n + 1 Längswiderständen 15 und Querwiderständen 16 und 2n Schmelzbrücken 17, die einen n-Bit Digital-Analog-Wandler darstellen gilt dann:

$$V_{tol} = \frac{V_{ref}}{2^n} \cdot \frac{R_L}{R + R_L} \cdot Z$$

mit

$$Z = \sum_{j=0}^{n-1} z_j 2^j$$

Im Rahmen der Fertigung des integrierten Bauelements kann in einer Endmessung der jeweilige Zusammenhang zwischen der Abstimmspannung und der Resonanzfrequenz des Schwingkreises 1 bestimmt und durch Brennen von Schmelzbrücken 17 kompensiert werden. Von besonderem Vorteil ist, daß der Abgleich mit Hilfe von mitintegrierten Schaltungskomponenten erfolgt.

**Patentansprüche**

1. Bauelement mit einer integrierten Schaltung für Hochfrequenzanwendungen in einem vorgegebenen Frequenzbereich, bei dem die integrierte Schaltung einen Schwingkreis (1) mit einer Kapazität (3, 7) aufweist, deren Wert durch eine Abstimmdiode (7) einstellbar ist, und weiterhin umfaßt:

   - einen Abstimmeingang (8), einen Abgleicheingang (10) und einen Schwingkreis (1);
   - eine Abstimmdiode (7), die an den Abstimmeingang (8) gekoppelt ist;
   - eine im Schwingkreis angeordnete Abgleichdiode (9), die an den Abgleicheingang (10) gekoppelt ist, wobei
   durch die Abgleichdiode (9) die herstellungsbedingten Abweichungen in der Resonanzfrequenz des Schwingkreises (1) kompensierbar sind;
   - einen Digital-Analog-Wandler (12), der eine Kette von Längswiderständen (15) aufweist, zwischen denen Querwiderstände (16) angeschlossen sind, weiterhin Schmelzverbindungen (17), eine Masseleitung, um ein Massepotential zu führen, und eine Referenzspannungsleitung aufweist, um eine Referenzspannung (Vref) zu führen und bei dem durch Brennen des Schmelzverbindungen (17) ein Digitalwert programmiert ist, so dass aus der Referenzspannung (Vref) eine Abgleichspannung (Vtol) erzeugt wird, die dem Abgleicheingang (10) zugeführt wird
   - wobei je zwei der Schmelzverbindungen (17) an einen der Querwiderstände (16) geschaltet sind, um die Querwiderstände (16) in Abhängigkeit von dem durch die Schmelzverbindungen programmierten Digitalwert wahlweise mit der Masseleitung oder der Referenzspannungsleitung zu verbinden, so daß die Abgleichspannung (Vtol) erzeugt wird.

2. Bauelement nach Anspruch 1,
   **dadurch gekennzeichnet, daß**
   der Schwingkreis (1) zwei gegeneinander gepolte Abstimmdioden (7) aufweist.

3. Bauelement nach Anspruch 2,
   **dadurch gekennzeichnet , daß**
   zwischen die Abstimmdioden (7) eine Abstimmspannung angelegt ist.

4. Bauelement nach einem der Ansprüche 1 bis 3,
   **dadurch gekennzeichnet , daß**
   die Abgleichdiode (9) parallel zur Kapazität des Schwingkreises (1) geschaltet ist.

5. Bauelement nach Anspruch 4,
   **dadurch gekennzeichnet , daß**
   zwei gegeneinander gepolte Abgleichdioden (9) parallel zur Kapazität des Schwingkreises (1) geschaltet sind.

6. Bauelement nach Anspruch 5,
   **dadurch gekennzeichnet , daß**
   zwischen die Abgleichdioden (9) die Abgleichspannung eingespeist ist.

7. Bauelement nach einem der Ansprüche 1 bis 6,
   **dadurch gekennzeichnet , daß**
   die Werte der Querwiderstände (16) das zweifache der Längswiderstände (15) betragen.

8. Bauelement nach einem der Ansprüche 1 bis 7,
   **dadurch gekennzeichnet, daß**
   der jeweilige mit den Schmelzverbindungen (17) verbundene Anschluss der Querwiderstände (16) mit einem jeweiligen Anschluss (18) verbunden ist, an den eine Spannung (F0, F1, ..., Fj) anlegbar ist, deren Höhe so eingestellt ist, dass eine der jeweiligen Schmelzverbindungen gebrannt wird.

9. Verwendung eines Bauelements für Hochfrequenzanwendungen zum Abgleichen von herstellungsbedingten Abweichungen mit den Schritten:

   - Bereitstellen eines Bauelements mit einer integrierten Schaltung für Hochfrequenzanwendungen in einem vorgegebenen Frequenzbereich, bei dem die integrierte Schaltung einen Schwingkreis (1) mit einer Kapazität (3, 7) aufweist, deren Wert durch eine Abstimmdiode (7) einstellbar ist, und weiterhin umfaßt:

      -- einen Abstimmeingang (8), einen Abgleicheingang (10) und einen Schwingkreis (1);
      -- eine Abstimmdiode (7), die an den Abstimmeingang (8) gekoppelt ist;
      -- eine im Schwingkreis angeordnete Abgleichdiode (9), die an den Abgleicheingang (10) gekoppelt ist, wobei durch die Abgleichdiode (9) die herstellungsbedingten Abweichungen in der Resonanzfrequenz des Schwingkreises (1) kompensierbar sind;
--einen Digital-Analog-Wandler (12) , der eine Kette von Längswiderständen (15) aufweist, zwischen denen Querwiderstände (16) angeschlossen sind, weiterhin Schmelzverbindungen (17), eine Masseleitung, um ein Massepotential zu führen, und eine Referenzspannungsleitung aufweist, um eine Referenzspannung (Vref) zu führen und bei dem durch Brennen des Schmelzverbindungen (17) ein Digitalwert programmiert ist, so dass aus der Referenzspannung (Vref) eine Abgleichspannung (Vtol) erzeugt wird, die dem Abgleicheingang (10) zugeführt wird
-- wobei je zwei der Schmelzverbindungen (17) an einen der Querwiderstände (16) geschaltet sind, um die Querwiderstände (16) in Abhängigkeit von dem durch die Schmelzverbindungen programmierten Digitalwert wahlweise mit der Masseleitung oder der Referenzspannungsleitung zu verbinden, so daß die Abgleichspannung (Vtol) erzeugt wird;

- Brennen einer der je zwei Schmelzverbindungen (17), um den jeweiligen Querwiderstand (16) wahlweise an die Masseleitung oder an die Referenzspannungsleitung anzuschließen, so dass der Digitalwert programmiert ist.

**Claims**

1. Component having an integrated circuit for radiofrequency applications in a predetermined frequency range, in which the integrated circuit has a resonant circuit (1) with a capacitance (3, 7) whose value can be set by a tuning diode (7), and furthermore comprises:

   - a tuning input (8), a trimming input (10) and a resonant circuit (1);
   - a tuning diode (7) coupled to the tuning input (8) ;
   - a trimming diode (9) arranged in the resonant circuit and coupled to the trimming input (10), it being possible for the production-dictated deviations in the resonant frequency of the resonant circuit (1) to be compensated for by the trimming diode (9);
   - a digital-to-analogue converter (12) having a chain of series-path resistors (15), between which parallel-path resistors (16) are connected, furthermore fusible links (17), a ground line for carrying a ground potential, and a reference voltage line for carrying a reference voltage (Vref), and in which a digital value is programmed by burning the fusible links (17), so that a trimming voltage (Vtol) is generated from the reference voltage (Vref), and is fed to the trimming input (10),
   - in each case two of the fusible links (17) being connected to one of the parallel-path resistors (16) in order optionally to connect the parallel-path resistors (16) to the ground line or the reference voltage line depending on the digital value programmed by the fusible links, so that the trimming voltage (Vtol) is generated.

2. Component according to Claim 1, **characterized in that** the resonant circuit (1) has two tuning diodes (7) connected with polarity in opposition to one another.

3. Component according to Claim 2, **characterized in that** a tuning voltage is applied between the tuning diodes (7).

4. Component according to one of Claims 1 to 3, **characterized in that** the trimming diode (9) is connected in parallel with the capacitance of the resonant circuit (1).

5. Component according to Claim 4, **characterized in that** two trimming diodes (9) connected with polarity in opposition to one another are connected in parallel with the capacitance of the resonant circuit (1).

6. Component according to Claim 5, **characterized in that** the trimming voltage is fed in between the trimming diodes (9).

7. Component according to one of Claims 1 to 6, **characterized in that** the values of the parallel-path resistors (16) are twice the series-path resistors (15).

8. Component according to one of Claims 1 to 7, **characterized in that** the respective terminal of the parallel-path resistors (16) which is connected to the fusible links (17) is connected to a respective terminal (18) to which can be applied a voltage (F0, F1, ..., Fj) whose magnitude is set such that one of the respective fusible links is burnt.

9. Use of a component for radiofrequency applications for trimming production-dictated deviations, comprising the steps of:

- providing a component having an integrated circuit for radiofrequency applications in a predetermined frequency range, in which the integrated circuit has a resonant circuit (1) with a capacitance (3, 7) whose value can be set by a tuning diode (7), and furthermore comprises:

-- a tuning input (8), a trimming input (10) and a resonant circuit (1);
-- a tuning diode (7) coupled to the tuning input (8);
-- a trimming diode (9) arranged in the resonant circuit and coupled to the trimming input (10),
it being possible for the production-dictated deviations in the resonant frequency of the resonant circuit (1) to be compensated for by the trimming diode (9);
-- a digital-to-analogue converter (12) having a chain of series-path resistors (15), between which parallel-path resistors (16) are connected, furthermore fusible links (17), a ground line for carrying a ground potential, and a reference voltage line for carrying a reference voltage (Vref), and in which a digital value is programmed by burning the fusible links (17), so that a trimming voltage (Vtol) is generated from the reference voltage (Vref), and is fed to the trimming input (10),
-- in each case two of the fusible links (17) being connected to one of the parallel-path resistors (16) in order optionally to connect the parallel-path resistors (16) to the ground line or the reference voltage line depending on the digital value programmed by the fusible links, so that the trimming voltage (Vtol) is generated;

- burning one of the in each case two fusible links (17) in order optionally to connect the respective parallel-path resistor (16) to the ground line or to the reference voltage line, so that the digital value is programmed.

## Revendications

1. Composant comprenant un circuit intégré pour des applications en haute fréquence dans un domaine de fréquence prescrit, dans lequel le circuit intégré a un circuit (1) oscillant ayant une capacité (3, 7), dont la valeur peut être réglée par une diode (7) d'accord et comprenant, en outre :

- une entrée (8) d'accord, une entrée (10) d'égalisation et un circuit (1) oscillant ;
- une diode (7) d'accord, qui est couplée à l'entrée (8) d'accord ;
- une diode (9) d'égalisation, montée dans le circuit oscillant et couplée à l'entrée (10) d'égalisation, dans lequel
les écarts de la fréquence de résonance du circuit (1) oscillant, qui sont dus à la fabrication, peuvent être compensés par la diode (9) d'égalisation ;
- un convertisseur (12) numérique-analogique qui a une chaîne de résistances (15) en série, entre lesquelles sont raccordées des résistances (16) transversales, en outre des liaisons (17) fusibles, une ligne à la masse pour appliquer un potentiel de masse et une ligne de tension de référence pour appliquer une tension (Vref) de référence et dans lequel une valeur numérique est programmée par claquage des liaisons (17) fusibles, de manière à obtenir à partir de la tension (Vref) de référence une tension (Vto1) d'égalisation qui est appliquée à l'entrée (10) d'égalisation ;
- dans lequel, respectivement, deux des liaisons (17) fusibles sont montées sur l'une des résistances (16) transversales pour relier les résistances (16) transversales en fonction de la valeur numérique programmée par les liaisons fusibles, au choix à la ligne de masse ou à la ligne de tension de référence, de manière à produire la tension (Vto1) d'égalisation.

2. Composant suivant la revendication 1, **caractérisé en ce que** le circuit (1) oscillant a deux diodes (7) d'accord de polarités opposées.

3. Composant suivant la revendication 2, **caractérisé en ce qu'**une tension d'accord est appliquée entre les diodes (7) d'accord.

4. Composant suivant l'une des revendications 1 à 3, **caractérisé en ce que** la diode (9) d'égalisation est montée en parallèle à la capacité du circuit (1) oscillant.

5. Composant suivant la revendication 4, **caractérisé en ce que** deux diodes (9) d'égalisation, polarisées en opposition, sont montées en parallèle à la capacité du circuit (1) oscillant.

6. Composant suivant la revendication 5, **caractérisé en ce que** la tension d'égalisation est appliquée entre les diodes (9) d'égalisation.

**7.** Composant suivant l'une des revendications 1 à 6, **caractérisé en ce que** les valeurs des résistances (16) transversales représentent deux fois celles des résistances (15) série.

**8.** Composant suivant l'une des revendications 1 à 7, **caractérisé en ce que** la borne respective des résistances (16) transversales, qui est reliée aux liaisons (17) fusibles, est reliée à une borne (18) respective à laquelle peut être appliquée une tension (F0, F1, ..., Fj) dont le niveau est réglé de façon à ce que l'une des liaisons fusibles respectives claque.

**9.** Utilisation d'un composant pour des applications en haute fréquence pour l'égalisation des écarts dus à la fabrication, comprenant les stades dans lesquels :

- on met à disposition un composant ayant un circuit intégré pour des applications en haute fréquence dans un domaine de fréquence prescrit, dans lequel le circuit intégré a un circuit (1) oscillant ayant une capacité (3, 7), dont la valeur peut être réglée par une diode (7) d'accord et comprenant, en outre :

-- une entrée (8) d'accord, une entrée (10) d'égalisation et un circuit (1) oscillant ;
-- une diode (7) d'accord, qui est couplée à l'entrée (8) d'accord ;
-- une diode (9) d'égalisation, montée dans le circuit oscillant et couplée à l'entrée (10) d'égalisation, dans lequel les écarts de la fréquence de résonance du circuit (1) oscillant, qui sont dus à la fabrication, peuvent être compensés par la diode (9) d'égalisation ;
-- un convertisseur (12) numérique-analogique qui a une chaîne de résistances (15) en série, entre lesquelles sont raccordées des résistances (16) transversales, en outre des liaisons (17) fusibles, une ligne à la masse pour appliquer un potentiel de masse et une ligne de tension de référence pour appliquer une tension (Vref) de référence et dans lequel une valeur numérique est programmée par claquage des liaisons (17) fusibles, de manière à obtenir à partir de la tension (Vref) de référence une tension (Vto1) d'égalisation qui est appliquée à l'entrée (10) d'égalisation ;
-- dans lequel, respectivement, deux des liaisons (17) fusibles sont montées sur l'une des résistances (16) transversales pour relier les résistances (16) transversales en fonction de la valeur numérique programmée par les liaisons fusibles, au choix à la ligne de masse ou à la ligne de tension de référence, de manière à produire la tension (Vt01) d'égalisation ;

- on fait claquer l'une de respectivement deux liaisons (17) fusibles pour raccorder la résistance (16) transversale respective au choix à la ligne de masse ou à la ligne de tension de référence, de manière à programmer la valeur numérique.

# FIG 1

FIG 2

FIG 3A    FIG 3B

$z_j = 1$    $z_j = 0$

EP 1 269 561 B1